# EUROPEAN PATENT APPLICATION

(11) **EP 1 162 749 A2**
(43) Date of publication of application: **12.12.2001**
(21) Application number: 01113414.5
(22) Date of filing: 01.06.2001
(51) Int. Cl.: H03M 3/02

(54) **Method and apparatus for digital-to-analog converting a signal modulated in the frequency domain**

(30) Priority: 09.06.2000 JP 2000173637
(71) Applicant: Burr-Brown Japan, Ltd., Atsugi-Shi, Kanagawa (JP)
(72) Inventor: Nakao, Shigetoshi, Komae-Oshi, Tokyo (JP); Hamasaki, Toshihiko, Yokohama-shi, Kanagawa (JP)
(74) Representative: Hartz, Nikolai F., Dr.

(57) **Abstract**

A digital-to-analog converter is provided for converting a digital input signal modulated in a frequency domain such as a delta-sigma modulated digital signal recorded in conformity with the DSD scheme to an analog output signal. The converter comprises a digital filter for filtering a digital input signal to generate a digitally filtered output signal comprised of a second number (N) of bits. and a digital-to-analog converting unit for converting the digitally filtered output signal to an analog form to generate an analog output signal.

## Description

### BACKGROUND OF THE INVENTION

The present invention relates generally to a method of converting a digital input signal to an analog output signal, and more particularly, to a method and apparatus for converting a sequence of digital signals modulated in a frequency domain to an analog signal, and a system which utilizes such method and apparatus.

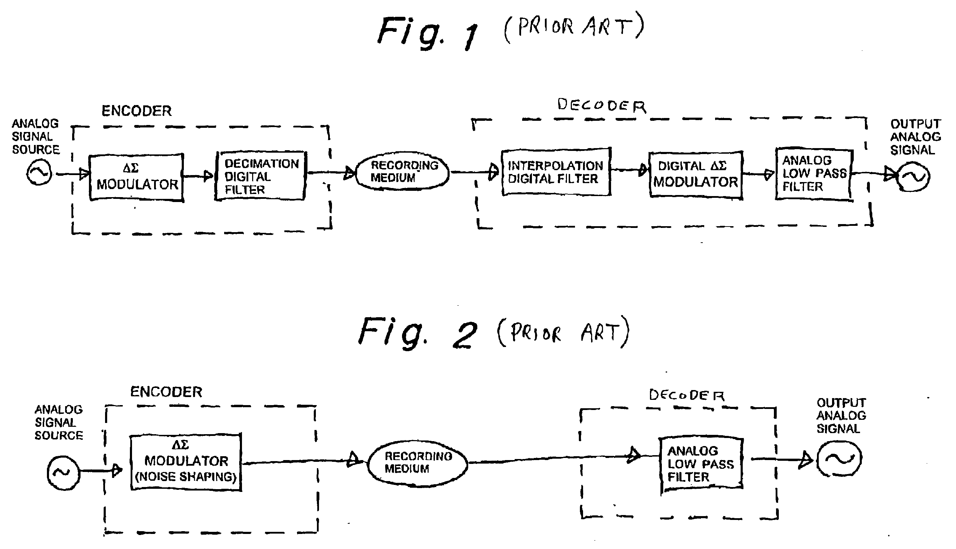

A variety of methods have been proposed for converting an analog signal to a digital signal and saving the digital signal on a recording medium. Also, a variety of methods have been proposed for converting a saved digital signal to an analog signal. For example, a PCM scheme, which is an approach of digitizing an audio signal, converts an analog signal at a sampling frequency of 44.1 kHz and at 16 bits of quantization level. The converted signal is represented on a coordinate system which represents the sampling frequency for determining a reproducible frequency band on the horizontal axis, and the quantization level for determining the magnitude of sound on the vertical axis. Conventionally, in the PCM scheme as mentioned, the processes of analog-to-digital conversion, digital recording and digital-to-analog conversion have been performed as illustrated in Fig. 1.

Specifically, as illustrated in Fig. 1, an audio analog signal is oversampled in an encoder at a frequency 0f 2.8224 MHZ which is 64 times higher than the sampling frequency of 44.1 kHz by a delta sigma type A/D converter to generate a 1-bit modulated digital signal. Then, the 1-bit modulated digital signal is converted to a 16-bit digital signal at 44.1 KHz by a decimation filter. Eventually, the resulting signal is saved on a recording medium such as a compact disc. For reproducing a saved signal, generally, the digital input signal is again over-sampled at 352.8 kHz, which is 8 times higher than the sampling frequency 44.1 kHz, by an interpolation filter in a decoder to be converted to a 24-bit digital signal which is further converted by an arbitrary D/A converter to reproduce an analog signal. The system of Fig. 1 has been referred to as a "super-audio CD" (SACD) system.

In recent years, a DSD (direct stream digital) scheme as illustrated in Fig. 2 has been proposed for analog-to-digital conversion, digital recording and digital-to-analog conversion, as an alternative to the PCM scheme.

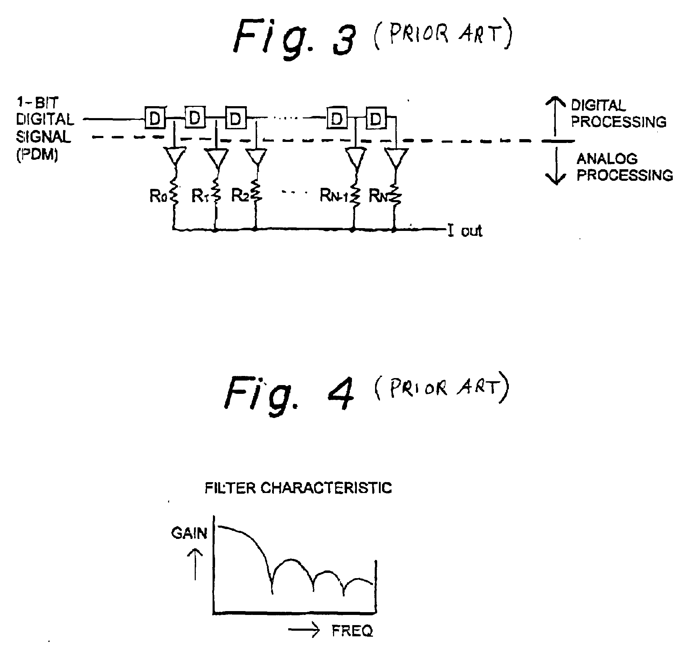

In the DSD scheme illustrated in Fig. 2, an analog signal is oversampled in an encoder at 2.8224 HMz, which is 64 times higher than the sampling frequency of 44.1 kHz. by a delta-sigma type A/D converter to be converted to a 1-bit pulse density modulated (PDM) digital signal. Immediately after the conversion, the 1-bit pulse density modulated digital signal is saved on a digital signal recording medium. For reproducing an analog signal from the 1-bit modulated digital signal, a sequence of the digital signals is averaged by an analog low pass filter or the like in a decoder as it is. The analog low pass filter employs a so-called analog FIR filter as illustrated in Fig. 3. This filter merely has ten taps at most, and can. only provide a low integer ratio as its coefficient ratio. The filter may be implemented by registers and weighting resistors, by way of example. See U.S. patent 4,947, 171 "Circuit Arrangement for Averaging Signals During Pulse-Density D/A for A/D Conversion" by Heinrich Pfeiffer et al., issued Aug. 7. 1990. Also see "Delta Modulation Systems", pp 337-353, by R. Steele et al., Pentech Press, 1975.

The DSD scheme is characterized by a gradually attenuating characteristic (see Fig. 4), in contrast with the PCM scheme (i.e., the SACD system of Fig. 1) which abruptly filters a signal at a certain frequency point, to permit reproduction of a signal over 100 kHz. However, with such an analog low pass filter having the characteristic as illustrated in Fig. 4, the conventional DSD scheme has a problem in that the analog low pass filter cannot avoid attenuating a frequency region which should not be essentially filtered, and cannot sufficiently filter out unwanted out-of-band noise components which arc dclta-sigma convened to move to a high frequency region. That is, the frequency region which should not be essentially filtered is below 20 kHz (in this example), and the region of unwanted out-of-band noise is above 20 kHz. The signal in such unwanted out-of-band noise is generated by the delta sigma converter of the ADC. The origin of this noise is in-band quantization noise, and that noise is shaped by the delta sigma modulator so as to be moved to the high-frequency out-of-band region. The filtering characteristic of the analog low pass filter is nor very sharp, so if there is substantial attenuation of the out-of-band signal, then there also will be undesirable filtering of the in-band signal.

More specifically, the DSD scheme which employs a conventional analog low pass filter to reproduce an analog signal is insufficient to provide an essentially desired analog signal, i.e., the conventional analog low pass filter is unable to produce an output with a sufficiently low noise level. For reproducing any desired analog signal, the number of taps must be several tens or more at minimum, and the ratio of a minimum coefficient to a maximum coefficient must be 100 or more. Further, as a more abrupt and larger attenuation characteristic is intended, a higher accuracy is required for the coefficients. Furthermore, an integrated circuit implementation of a conventional analog-FIR filter having the accuracy needed for the DSD scheme requires a very large silicon chip, and therefore it is very expensive.

Thus, there is an unmet need for an improved analog FIR filter having the accuracy needed for the above described DSD scheme and which can be implemented on an integrated circuit chip at a reasonably low cost.

### SUMMARY OF THE INVENTION

It is therefore an object of the present invention to provide an improved analog-to-digital converting method and apparatus for converting a digital input signal modulated in a frequency domain, such as a delta-sigma modulated signal recorded in conformity with the DSD scheme, to an analog output signal.

It is another object of the present invention to provide a digital-to-analog converting method and apparatus for use in the reproduction of an analog signal from a signal such as a delta-sigma modulated digital signal recorded in conformity with the DSD scheme, which is capable of substantially completely eliminating out-of-band noise components of a delta-sigma modulated digital signal from the analog signal and which is capable of arbitrarily setting pass and block characteristics simultaneously to of a filter receiving the delta-sigma modulated digital signal.

It is a further object of the present invention to provide a digital-to-analog conversion method and system as stated above for super-audio CD (SACD) recording/reproduction.

To achieve the above objects, according to the present invention, a digital-to-analog converting method converts a digital input signal comprised of a first number (M) of bits, which is modulated in a frequency domain. The method comprises the steps of digitally filtering the digital input signal to generate a digitally filtered output signal comprised of a second number (N) of bits; and converting the digitally filtered output signal to an analog form to generate the analog output signal.

Also, according to the present invention, a DSD signal decoding method comprises the step of using the foregoing digital-to-analog converting method according to the present invention to convert a DSD-based digital input signal to an analog output signal.

Further, according to the present invention, a super-audio CD (SACD) reproducing method comprises the step of using the foregoing digital-to-analog converting method according to the present invention to reproduce from a digital signal recorded on a super-audio CD an original analog signal represented by the digital signal.

Further, according to the present invention, a method of recording and reproducing an analog signal using a super-audio CD comprises the steps of encoding the analog signal, including: 1) converting the analog signal to a digital signal modulated in a frequency domain; and ii) recording the modulated digital signal on the super-audio CD; and decoding the modulated digital signal recorded on the super-audio CD, including: I) receiving the modulated digital signal; and ii) generating an analog signal from the rcccivcd modulated digital signal using the foregoing digital-to-analog converting method according to the present invention.

In addition, according to the present invention, a digital-to-analog converter converts a digital input signal comprised of a first number (M) of bits, which is modulated in a frequency domain. The converter comprises digital filtering means for digitally filtering the digital input signal to generate a digitally filtered output signal comprised of a second number (N) of bits; and digital-to-analog converting means for converting the digitally filtered output signal to an analog form to generate the analog output signal.

Also, according to the present invention, a direct stream digital signal decoder converts a DSD-based digital input signal to an analog output signal. The decoder comprises the foregoing digital-to-analog converter according to the present invention.

Further, according to the present invention, a super-audio CD (SACD) reproducing apparatus reproduces from a digital signal recorded on a super-audio CD an original analog signal represented by the digital signal. The reproducing apparatus comprises the digital-to-analog converter according to the present invention.

Further, according to the present invention, an apparatus for recording and reproducing an analog signal using a super-audio CD (SACD) comprises an encoder which includes modulating means for converting the analog signal to a digital signal modulated in a frequency domain; and a decoder which includes digital-to-analog converting means coupled to receive the modulated digital signal recorded on the super-audio CD for converting the received modulated digital signal to an analog signal using the foregoing digital-to-analog converter according to the present invention.

### BRIEF DESCRIPTION OF THE DRAWINGS

Fig. 1 is a block diagram illustrating a system which performs analog-to-digital conversion, digital recording and digital-to-analog conversion in accordance with the conventional PCM scheme.
Fig. 2 is a block diagram illustrating a system which performs analog-to-digital conversion, digital recording and digital-to-analog conversion in accordance with the conventional DSD scheme.
Fig. 3 is a circuit diagram of a conventional analog FIR filter.
Fig. 4 is a graph illustrating the filter characteristic of the analog FIR filter of Fig. 3.
Fig. 5 is a block diagram illustrating a digital-to-analog converter according to the present invention.
Fig. 6 is a specific circuit diagram of the digital-to-analog converter illustrated in Fig. 5, depicting in detail a digital filter.
Fig. 7 is a block diagram illustrating an embodiment of the digital-to-analog converter of Fig. 5 which uses a digital low pass filter, and also shows noise levels at certain positions in the block diagram.
Fig. 8 is a block diagram illustrating an alternative embodiment of the digital-to-analog converter of Fig. 7 which uses a DS digital-to-analog converter, and also shows noise levels at certain positions in the block diagram.
Fig. 9 is a block diagram illustrating another alternative embodiment of the digital-to-analog converter of Fig. 5 which uses a decimation filter, and also shows noise levels at certain positions in the block diagram.

### DETAILED DESCRIPTION OF THE INVENTION

The present invention will hereinafter be described in connection with several embodiments thereof with reference to the accompanying drawings.

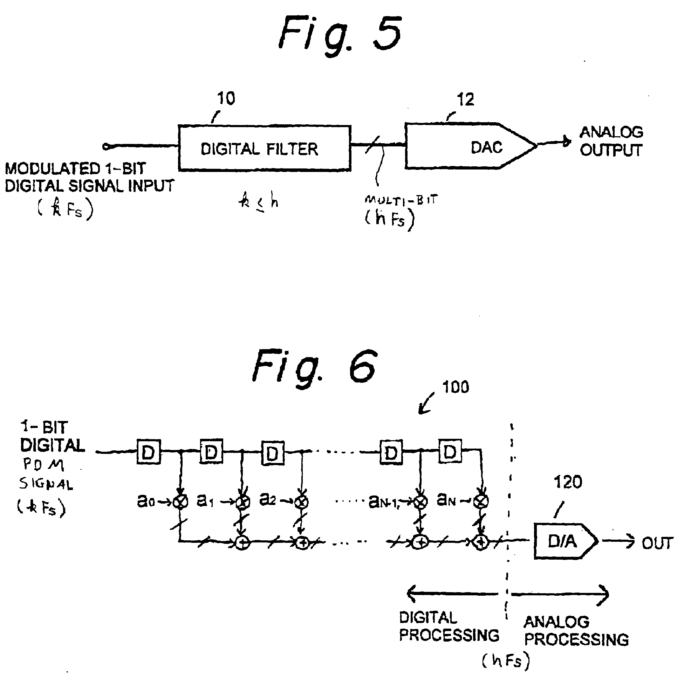

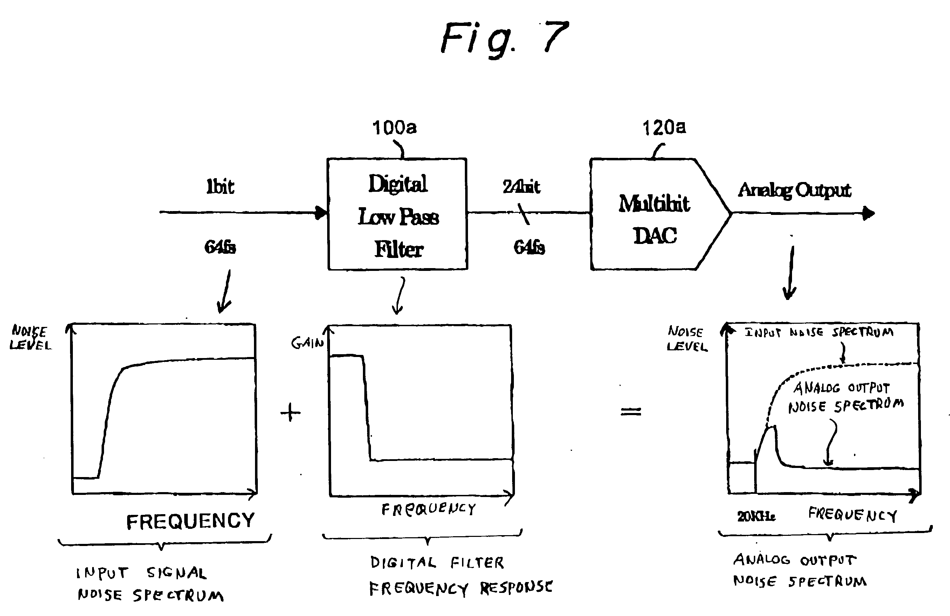

Fig. 5 is a block diagram illustrating a basic concept of the present invention, and specifically depicts a digital-to-analog converter for converting a 1-bit digital input signal, which is modulated in a frequency domain, to an analog signal. The converter comprises a digital filter 10, and a digital-to-analog converter (DAC) 12. The frequency of the 1-bit digital input signal is k multiplied by Fs, where Fs is the sampling frequency and k is less than or equal to h, where k represents the over-sampling ratio of the digital input signal and h represents the over-sampling ratio of the digital filter output signal. Note that the foregoing statements also arc true for the circuits shown in subsequently described in Figs. 7-9. Note also that this is in contrast to the prior art digital filters which are referred to as interpolation digital filters, wherein k is greater than h.

In the present invention, the digital filter may be an FIR filter 100 for digitally processing weighted addition of taps, as illustrated in Fig. 6. It should be noted however that an IIR filter may be used instead as a filter suitable for the purpose of the present invention.

The output of the filter may be converted to an analog form using a segment type or an R-2R type digital-to-analog converter. This filter is advantageous in that an arbitrary characteristic can be readily created because the processing involved in the filter can be performed in a digital domain. The basic configuration of the digital filter 10 is illustrated in Fig. 6. In Fig. 6, the elements "D" are D-type flip-flops, the elements "X" are digital multipliers, and the elements "+" are digital adders. Digital filter 100 receives 1-bit data as its input and produces the bit data as its output. Note that digital filter 100. with 1-bit data as its input and having a multi-bit output associated with the same ovcrsampling ratio for both its input signal and its output signal, is novel.

Fig. 7 illustrates an embodiment of a digital-to-analog converter which omits decimation. The illustrated digital-to-analog converter comprises a digital low pass filter 100a, and a multibit DAC 120a. A digital input signal is a 1-bit signal at 64 Fs (Fs = 44.1 kHz, Fs being the sampling frequency) which is A/D converted by 64-times over-sampling.

Fig. 7 also shows noise levels at the input of the digital low pass filter 100a, the output of the low pass filter 100a, and the output of the DAC 120a (the horizontal axis represents the frequency, and the vertical axis represents the noise level). For the illustrated 1-bit input signal spectrum, the vertical axis represents the noise level. The graphs of frequency response in Fig. 7 are intended to conceptually show how the method of the present invention rejects out-of-band noise in input data. An input noise level is indicated by a dotted line in the graph of the frequency response for the Analog Output of DAC 120a to show the noise level of the analog output which is much lower than the noise level of the 1-bit digital input of digital low pass filter 100a over most of the frequency spectrum above 20 kHz. It should be noted that since this method must digital-to-analog convert a sequence of digital data at a frequency as high as 64 Fs (Fs= 44.1 kHz), a relatively fast multibit digital-to-analog converter is required.

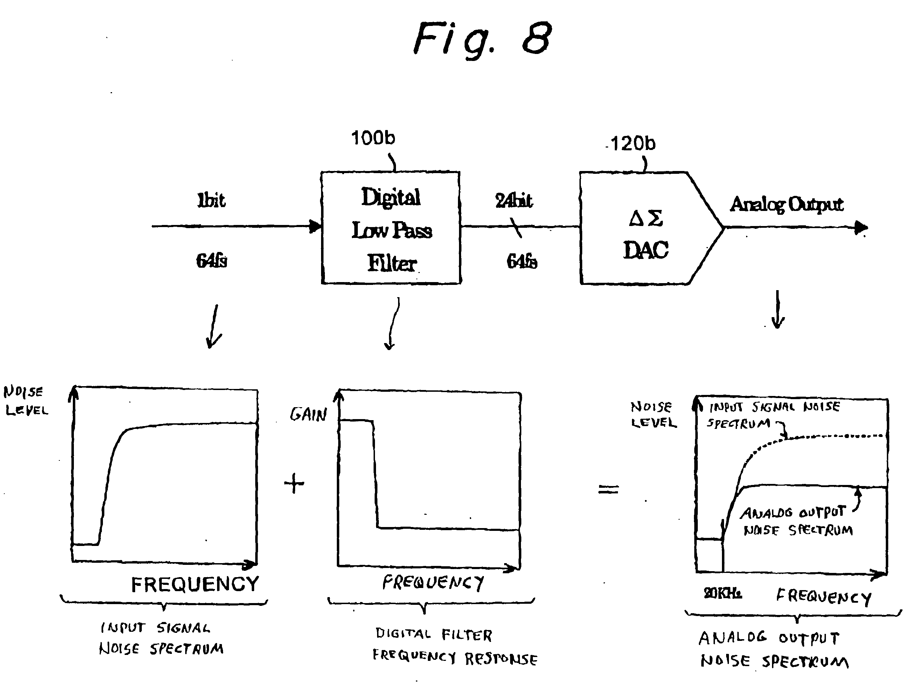

Fig. 8 illustrates another embodiment of the digital-to-analog converter according to the present invention which is similar in configuration to the digital-to-analog converter 10 of Fig. 7, except that it employs a delta-sigma digital-to-analog converter instead of the multibit DAC 120 as the DAC. The digital-to-analog converter using the delta-sigma digital-to-analog converter can operate similarly to the digital-to-analog converter of Fig. 7, as can be understood from noise levels shown in Fig. 8. As is the case of Fig. 7, an input noise level is indicated in Fig. 8 by a dotted line for comparison in the graph showing the noise level of the analog output. The embodiment of Fig. 8 also provides an analog output having a noise level much lower than the noise level of the 1-bit digital input for most of the frequency region above 20 kHz. It should be noted, however, that the noise level is slightly higher above 20 KHz as compared with that in Fig. 7.

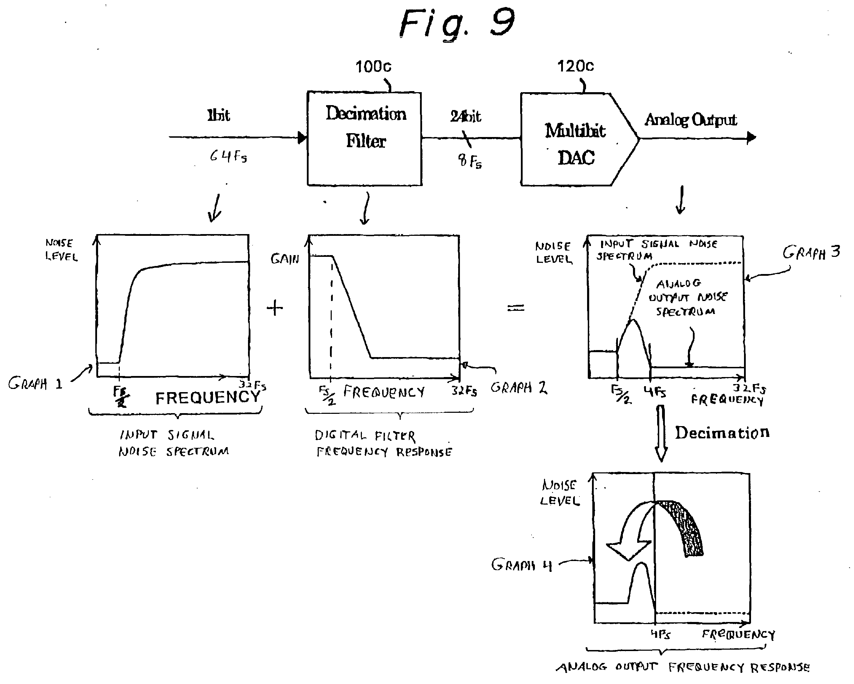

Fig. 9 illustrates another alternative embodiment of the digital-to-analog converter according to the present invention which employs a decimation filter in a digital signal processing unit or a digital filter. As illustrated, the digital-to-analog converter comprises a decimation filter 100c and a multibit DAC 120c. In this embodiment, the decimation is relied on to convert data at 64 Fs to 24-bit binary data at 8 Fs (or possibly 16 Fs). As a result, the clock speed of the digital data sequence is reduced by a factor of eight (or possibly 16), so that the conversion rate of the multibit DAC can be reduced. The embodiment of Fig. 9 provides an analog output in which the noise level is even more substantially lower than is the case for the embodiment of Fig. 7 for the frequency spectrum above 20 kHz (Fs = 40 kHz). (However, in implementing the decimation filter, the steep-sloped, high-stop-band attenuation cannot be easily obtained with a reasonable circuit scale compared to that of the interpolation filter as shown in Graph 2 of Fig. 9.) It should be noted that the decimation of data results in aliasing of noise into the band, so the frequency characteristic of the decimation filter 100c must be determined such that the aliasing noise does not affect in-band signals.

The foregoing embodiments should be selected for use in a particular application based on required specifications, i.e., total determination of the filter characteristics, a circuit scale, the characteristic of the digital-to-analog converter, and so on. Anyway, the method and apparatus according to the present invention can bring out high analog performance (i.e., no degradation of signal level frequency response, and low out-of-band noise) which cannot be accomplished by any conventional scheme.

The foregoing analog-to-digital converter according to the present invention can be used in the SACD recording/reproducing system previously illustrated in Fig. 2 as a digital-to-analog converter.

As described above, the method of the present invention filters a digital input signal in a digital domain, and analog-to-digital converts the resulting output to an analog output. This method, when used, can equivalently realize a highly accurate analog FIR filter in an extremely small area. The filter characteristic for data is largely affected by the number of taps for a group of filter coefficients, a coefficient ratio, and its relative accuracy. For example, the number of taps may be required to be several tens or more; the coefficient ratio to be 100 or more; and the absolute accuracy of coefficients to be approximately 0.01%. Such requirements to weighting and the number of taps have not been satisfied by any conventional analog FIR filter as an integrated circuit of economically feasible size.

## Claims

1. A digital-to-analog convening method for converting a digiral input signal comprised of a first number (M) of bits, said digital input signal being modulated in a frequency domain, said method comprising the steps of:
digitally filtering said digital input signal to generate a digitally filtered output signal
comprised of a second number (N) of bits; and
converting said digitally filtered output signal to an analog form to generate said analog output signal;
wherein said digital input signal has a frequency kFs and wherein the digitally filtered output signal has a frequency hFs, wherein k represents an ovcr-sampling rate of said digital input signal. Fs is the sampling frequency, wherein k is less than or equal to h, and wherein h represents the over-sampling rate of said analog output signal.

2. A digital-to-analog converting method for convening a digital input signal comprised of a first number (M) of bits, said digital input signal being modulated in a frequency domain, said method comprising the steps of:
digitally filtering said digital input signal to generate a digitally filtered output signal
comprised of a second number (N) of bits; and
converting said digitally filtered output signal to an analog form to generate said analog output signal;
wherein said digital input signal has a frequency kFs and wherein the digitally filtered output signal has a frequency hFs. wherein k represents an over-sampling rare of said digital input signal, Fs is the sampling frequency, wherein k is less than or equal to h, wherein h represents the over-sampling rate of said analog output signal, and wherein said digital input signal is a delta-sigma modulated signal.

3. A digital-to-analog converting method according to claim 1, wherein said digitally filtered output signal is a binary code.

4. A digital-to-analog converting method for converting a digital input signal comprised of a first number (M) of bits, said digital input signal being modulated in a frequency domain, said method comprising the steps of:
digitally filtering said digital input signal to generate a digitally filtered output signal
comprised of a second number (N) of bits; and
converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, wherein h represents the over-sampling rate of said analog output signal, and wherein said digital filtering includes decimation.

5. A digital-to-analog converting method according to claim 4, wherein said digital filtering is performed using a digital decimation filter.

6. A digital-to-analog converting method for converting a digital input signal comprised of a first number (M) of bits, said digital input signal being modulated in a frequency domain, said method comprising the steps of:
digitally filtering said digital input signal to generate a digitally filtered output signal
comprised of a second number (N) of bits; and
converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal, wherein said digital filtering does not include decimation, and wherein said digital filtering is performed using a digital FIR filter.

7. A digital-to-analog converting method for converting a digital input signal comprised of a first number (M) of bits, said digital input signal being modulated in a frequency domain, said method comprising the steps of:
digitally filtering said digital input signal to generate a digitally filtered output signal
comprised of a second number (N) of bits; and
converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal, wherein said digital filtering does not include decimation, and wherein said digital filtering is performed using a digital IIR filter.

8. A digital-to-analog converting method for convening a digital input signal comprised of a first number (M) of bits, said digital input signal being modulated in a frequency domain, said method comprising the steps of:
digitally filtering said digital input signal to generate a digitally filtered output signal
comprised of a second number (N) of bits; and
converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal, wherein said second number (N) is larger than said first number (M).

9. A digital-to-analog converting method for converting a digital input signal comprised of a first number (M) of bits, said digital input signal being modulated in a frequency domain, said method comprising the steps of:
digitally filtering said digital input signal to generate a digitally filtered output signal
comprised of a second number (N) of bits; and
converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal, wherein said step of convening includes using a multi-bit digital-to-analog converter

10. A digital-to-analog converting method for converting a digital input signal comprised of a first number (M) of bits, said digital input signal being modulated in a frequency domain, said method comprising the steps of:
digitally filtering said digital input signal to generate a digitally filtered output signal
comprised of a second number (N) of bits; and
converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal, wherein said step of convening includes using a delta-sigma digital-to-analog converter.

11. A digital-to-analog converting method for converting a digital input signal comprised of a first number (M) of bits, said digital input signal being modulated in a frequency domain, said method comprising the steps of:
providing said digital input signal as a signal in conformity with a direct stream digital (DSD) scheme;
digitally filtering said digital input signal to generate a digitally filtered output signal
comprised of a second number (N) of bits; and
converting said digitally filtered output signal to an analog form to generate said analog output signal:
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal.

12. A DSD signal decoding method comprising the step of using a digital-to-analog converting method according to claim 1 to convert a DSD-based digital input signal to an analog output signal.

13. A super-audio CD (SACD) reproducing method comprising the step of using a digital-to-analog converting method according to claim 1 to reproduce from a digital signal recorded on a super-audio CD an original analog signal represented by said digital signal.

14. A method of recording and reproducing an analog signal using a super-audio CD, comprising the steps of:
encoding said analog signal, including:
i) converting said analog signal to a digital signal modulated in a frequency domain; and
ii) recording said modulated digital signal on the super-audio CD; and
decoding said modulated digital signal recorded on said super-audio CD, including:
i) receiving said modulated digital signal; and
ii) generating an analog signal from said received modulated digital signal using a digital-to-analog converting method according to claim 1.

15. A digital-to-analog converter for converting a digital input signal comprised of a first number (M) of bits, said digital input signal modulated in a frequency domain, said convener comprising:
digital filtering means for digitally filtering said digital input signal to generate a digitally filtered output signal comprised of a second number (N) of bits;
digital-to-analog converting means for converting said digitally filtered output signal to an analog form to generate said analog output signal; and
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal.

16. A digital-to-analog converter according to claim 15, wherein said digital input signal is a delta-sigma modulated signal.

17. A digital-to-analog converter according to claim 15, wherein said digitally filtered output signal is a binary code.

18. A digital-to-analog converter according to claim 15, wherein said digital filtering means performs decimation.

19. A digital-to-analog converter according to claim 18, wherein said digital filtering means comprises a digital decimation filter.

20. A digital-to-analog converter according to claim 15, wherein said digital filtering means does not perform decimation.

21. A digital-to-analog converter according to claim 20, wherein. said digital filtering means comprises a digital FIR filter.

22. A digital-to-analog converter according to claim 15, wherein said second number (N) is larger than said first number (M).

23. A digital-to-analog converter according to claim 15, wherein said converting means comprises a delta-sigma digital-to-analog converter.

24. A digital-to-analog converter according to claim 15, wherein said converting means comprises a multibit digital-to-analog converter.

25. A digital-to-analog converter according to claim 15, wherein said digital input signal is a signal is a direct stream digital (DSD) signal.

26. A direct stream digital signal decoder for converting a DSD-based digital input signal to an analog output signal, said decoder comprising a digital-to-analog convener according to claim 14.

27. A super-audio CD (SACD) reproducing apparatus for reproducing from a digital signal recorded on a super-audio CD an original analog signal represented by said digital signal, said reproducing apparatus comprising a digital-to-analog converter according to claim 15.

28. An apparatus for recording and reproducing an analog signal using a super-audio CD (SACD) comprising:
an encoder, said encoder including modulating means for converting said analog signal to a digital signal modulated in a frequency domain; and
a decoder, said decoder including digital-to-analog converting means coupled to receive said modulated digital signal recorded on said super-audio CD for converting said received modulated digital signal to an analog signal using a digital-to-analog converter according to claim 15.

29. A digital-to-analog convening circuit for converting a digital input signal comprised of a first number (M) of bits, said digital input signal being modulated in a frequency domain, said circuit comprising:
a digital low pass filter for digitally filtering said digital input signal to generate a digitally filtered output signal comprised of a second number (N) of bits; and
a delta-sigma digital-to-analog converter for converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal.

30. A digital-to-analog converting circuit for converting a digital input signal comprised of a first number (M) of bits, said digital input signal being modulated in a frequency domain, said circuit comprising:
a digital low pass filter for digitally filtering said digital input signal to generate a digitally filtered output signal comprised of a second number (N) of bits, said digital input signal being a signal in conformity with a direct stream digital (DSD) scheme; and
a delta-sigma digital-to-analog converter for converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal.

31. A digital-to-analog converting circuit for converting a digital input signal comprised of a first number (M) of bits, said digital input signal being modulated in a frequency domain, said circuit comprising:
a digital low pass filter for digitally filtering said digital input signal to generate a digitally filtered output signal comprised of a second number (N) of bits; and
a multi-bit digital-to-analog converter for converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the over-sampling rate of said analog output signal.

32. A digital-to-analog convening circuit for converting a digital input signal comprised of a first number (M) of bits, said digital input signal being modulated in a frequency domain, said circuit comprising:
a decimation filter for digitally filtering said digital input signal to generate a digitally filtered, decimated output signal comprised of a second number (N) of bits; and
a multi-bit digital-to-analog converter for converting said digitally filtered output signal to an analog form to generate said analog output signal;
wherein said digital input signal has a frequency kFs and wherein the digitally filtered output signal has a frequency hFs, wherein k represents an over-sampling rate of said digital input signal, Fs is the sampling frequency, wherein k is less than or equal to h, and wherein h represents the oversampling rate of said analog output signal.
